Europäisches Patentamt

(19) European Patent Office

Office européen des brevets

(11) Publication number: **0 039 192**
A2

## (12) EUROPEAN PATENT APPLICATION

(21) Application number: **81301742.3**

(22) Date of filing: **21.04.81**

(51) Int. Cl.³: **H 04 N 3/15**
**H 01 L 27/14, H 01 L 29/78**

(30) Priority: **25.04.80 US 143588**

(43) Date of publication of application:
**04.11.81 Bulletin 81/44**

(84) Designated Contracting States:
**DE FR GB IT NL SE**

(71) Applicant: **Hughes Aircraft Company**
**Centinela Avenue and Teale Street**
**Culver City California 90230(US)**

(72) Inventor: **Maeding, Dale**
**31712 Avenue of Avilla**
**San Juan Capistrano California 92675(US)**

(74) Representative: **Colgan, Stephen James et al,**
**CARPMAELS & RANSFORD 43 Bloomsbury Square**
**London WC1A 2RA.(GB)**

(54) CCD imager detector buffer.

(57) A photodetector buffer for a charge coupled device having a linear response includes a field effect transistor having its drain and gate connected to the photodetector output, the gate also being connected to a control electrode overlying an output charge flow channel. The response of the device is inherently linear and non-inverting and is substantially insensitive to threshold voltage nonuniformities.

Croydon Printing Company Ltd.

./...

Fig. 3.

# CCD IMAGER DETECTOR BUFFER

## TECHNICAL FIELD

The invention is related to charge coupled device imagers in which a semiconductive photodetector generates a photocurrent controlling the injection of charge packets into an adjacent charge coupled device output register.

## BACKGROUND ART

Charge coupled device imagers of the type disclosed in Sequin, et al., Charge Transfer Devices, Academic Press, New York 1975, typically include a semiconductive photodetector formed on a semi-conductive substrate generating a photocurrent which controls the injection of charge packets into a charge coupled device (CCD) serial output register also formed on the substrate. One problem encountered with semiconductive photodetectors responsive to infrared radiation is that the photocurrent generated by the infrared detector may not be sufficient to inject enough charge into the CCD output register to be distinguished from the background charge level or noise of the CCD register. In such a case, the video signal generated by the photodetector is lost to CCD noise. This problem is solved by the use of an amplifier for injecting sufficiently large charge packets into the CCD register in response to the photocurrent. The amplifier also isolates the low source impedance of the infrared detector from the CCD register.

Prior art buffer amplifiers useful in CCD imagers include both d.c. coupled and a.c. coupled amplifiers. Typically, the buffer amplifier comprises a metal oxide semiconductor (MOS) field effect transistor (FET) having its drain and gate connected together and connected to a drain voltage supply and its source connected to receive the photocurrent from the detector. The source voltage of the buffer MOSFET controls the voltage on an electrode in the CCD register regulating the injection of charge packets into the CCD register. The device operates so that the source current through the buffer MOSFET equals the detector current and the source voltage therefore follows the detector current. Thus, the source voltage of the MOSFET is a video signal representing the image viewed by the photodetector. The source of the MOSFET is connected to the CCD injection gate either directly (for d.c. coupling) or through a capacitor (for a.c. coupling).

A significant disadvantage of such prior art buffer amplifiers is that the CCD current response is a highly nonlinear hyperbolic inverting function of the photodetector current. It should be noted that the ideal CCD current response would be a non-inverting linear function of the photodetector current.

Another disadvantage of such prior art buffer amplifiers is that the CCD output current is highly threshold sensitive, being an exponential function of the sum of the load MOSFET threshold voltage and the CCD input gate threshold voltage. Typically, CCD imagers include a plurality of photodetectors controlling the injection of charge packets into a corresponding plurality of CCD registers. The MOSFET threshold voltage and the CCD threshold voltage may vary widely between the plurality of photodetector-CCD register pairs. As a result, for a given amount of incident radiation, some of the CCD registers may be saturated by the photodetector output while other CCD registers may have a very small response which is lost to CCD noise.  Such a situation severely limits the dynamic range of the video signal generated by the CCD imager and, more importantly, introduces nonuniformities into the video signal generated by the imager.

Another problem with such prior art devices is that background leakage currents are unavoidably generated which affect the output video signal of the imager. Specifically, each CCD output register is isolated from the photodetector by a channel stop diffusion or implant in the substrate comprising a semiconductive region of opposite conductivity with respect to the conductivity of the photodetector diffusion. Because the photodetector must be connected to the source of the load MOSFET in the prior art buffer amplifiers, as discussed above, the junction formed between the photodetector diffusion and the channel stop is forward-biased by the detector bias voltage, which typically creates a leakage current.

## SUMMARY OF THE INVENTION

All of the foregoing problems are solved in a novel buffer amplifier useful in a CCD imager.  The buffer amplifier of the present invention comprises a load MOSFET having its gate connected to its drain and connected to both the photodetector output and to the CCD charge injection control electrode or " input gate". The CCD output current response as a function of photodetector current is highly linear and non-inverting in this invention.  Furthermore, the output CCD current is an exponential function of the difference between the threshold voltage of the load MOSFET and the threshold voltage of the CCD input gate.  Inasmuch as these two threshold voltages are nearly equal to one another by reason of the close proximity of the MOSFET gate and the CCD input gate, the current is substantially insensitive to variations in threshold voltage. As a result, in a CCD imager comprising a plurality of photodetectors controlling injection of charge packets into a plurality of CCD registers through a plurality of buffer amplifiers of the present invention, the CCD current response will be substantially uniform among the plurality of photodetector-CCD register pairs regardless of variations in the threshold voltages of the plurality of load MOSFETs and of the plurality of CCD registers. Therefore, the dynamic range of the imager is greatly improved. Finally, because the photodetector output is connected to the drain of the load MOSFET, the photodetector diffusion is reverse biased in the present invention, thus eliminating the leakage currents generated in the prior art devices described above.

## DESCRIPTION OF THE DRAWINGS

The invention is best understood by reference to the accompanying drawings of which:

FIG. 1 is a schematic diagram of a portion of a CCD imager of the prior art;

FIG. 2 is a graph of the response of the CCD imager of FIG. 1;

FIG. 3 is a schematic diagram of the preferred embodiment of the present invention; and

FIG. 4 is a graph of the response of the device illustrated in FIG. 3.

## DETAILED DESCRIPTION

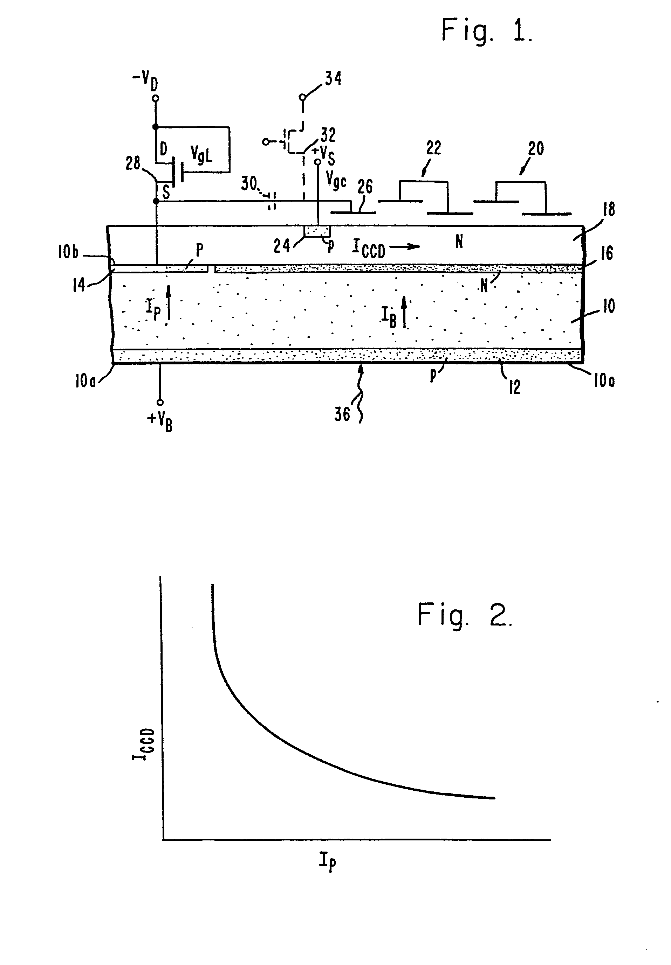

Referring to the schematic diagram of the prior art CCD imaging device of FIG. 1, an infrared photodetector comprising a semiconductive substrate 10 of indium doped silicon has its back face 10a covered by a p-type diffusion 12. The top face 10b of the substrate 10 has a photoconductor portion defined by a photocurrent-receiving p-type diffusion 14 and an n-type diffusion channel stop 16. The top face 10b is covered by an epitaxial silicon layer 18 of n-type conductivity in which a p-channel charge coupled device (CCD) serial output register 20 is defined by an overlying plurality of clocked electrodes 22, an input p-type diffusion 24 and a charge injection control gate 26. A load MOSFET 28 comprises a buffer amplifier having its source connected to the photocurrent-receiving diffusion 14 and to the CCD charge injection control electrode or gate 26. The drain and gate of the MOSFET 28 are connected together and to a drain voltage source $(-V_d)$. While the solid line configuration illustrated in FIG. 1 provides d.c. coupling between the buffer amplifier and the CCD injection gate 26, a.c. coupling may be provided by interposing a coupling capacitor 30 between the source of the MOSFET 28 and the injection gate 26 and by connecting a reset transistor 32 between one plate of the capacitor 30 and a reset voltage source 34 and periodically applying a reset clock signal to the gate of the reset transistor 32.

The buffer amplifier load MOSFET 28 is a p-channel device formed in the silicon layer 18 and has a negative threshold voltage $V_{tL}$ such that whenever the voltage $V_{gL}$ applied to the gate of the transistor 28 is more negative than the threshold voltage $V_{tL}$, positive minority carriers flow from the source to the drain of the MOSFET 28. Similarly, whenever the voltage $V_{gc}$ applied to the CCD injection gate 26 is more negative than the threshold voltage $V_{tc}$ of the CCD register 20, positive minority carriers flow from the input diffusion 24 to be stored beneath the clocked transfer electrodes 22.

If radiation 36 of an infrared frequency strikes the photodetector diffusion 12 on the back surface 10a,

a photocurrent $I_p$ flows from the photodiffusion 12 to the photocurrent-receiving diffusion 14. The source voltage of the load transistor 28 follows the photocurrent $I_p$ and is applied to the CCD injection control gate 26. Therefore, the charge injected from the input diffusion 24 into the CCD register 20 follows the photocurrent $I_p$. Consequently, a serial train of charge packets is injected from the input diffusion 24 under control of the injection gate 26 to be transferred under successive ones of the clock transfer electrodes 22, the packets representing a video signal in response to the radiation 36 incident on the back face 10a. It should be noted that a positive voltage $+V_b$ must be applied to the photodiffusion 12 and a negative voltage must be applied to the drain of the MOSFET 28.

A significant disadvantage of the prior art device of FIG. 1 is that the current $I_{CCD}$ of charge packets flowing in the serial output register 20 is a nonlinear inverting function of the photocurrent $I_p$. Therefore, nonlinearities are introduced into the video output signal comprising the output current $I_{CCD}$. An exemplary transfer function, $(I_{CCD})/(I_p)$, of the device of FIG. 1 is plotted in FIG. 2 and may be qualitatively derived using principles well-known in the art.

Significantly, the output current $I_{CCD}$ of charge packets transferred serially in the output CCD register 20 is an exponential function of the sum of the threshold voltages of the load MOSFET 28 and of the CCD injection gate 26. This may be expressed as:

$$I_{CCD} \quad \exp (V_{tL} + V_{tc})$$

The foregoing expression may also be qualitatively derived using principles well-known in the art. It is seen from this algebraic expression that the output current $I_{CCD}$ is highly sensitive to variations in the threshold voltages $V_{tL}$ and $V_{tc}$.

Sensitivity of the output current $I_{CCD}$ to the threshold voltage $V_{tL}$ and $V_{tc}$ creates a severe problem because a complete CCD imager includes a plurality of photosensor-CCD register pairs such as the one shown in FIG. 1. Each of these pairs is formed in different portions of the semiconductive substrate 10. As is well-known in the metal oxide semiconductor processing arts, the threshold voltages $V_{tL}$ and $V_{tc}$ of the plurality of photosensor-CCD register pairs may vary widely between pairs because of processing nonuniformities in different areas of the substrate 10. Specifically, the threshold voltages $V_{tL}$ and $V_{tc}$ may differ from a nominal value of -1.5 volts by a deviation as large as 30 millivolts between various photosensor-output register pairs in different portions of the substrate 10. As a result, the various output currents $I_{CCD}$ for different photosensor-output register pairs may vary so widely that one output register may be saturated while another may have no signal for the same photocurrent $I_p$.

Another problem with the device of FIG. 1 is that the p-type photodiffusion 12 has an applied positive voltage $+V_b$ and is therefore forward biased with respect to the channel stop 16. As a result, a background leakage current $I_B$ may flow between the photodiffusion 12 and the channel stop 16.

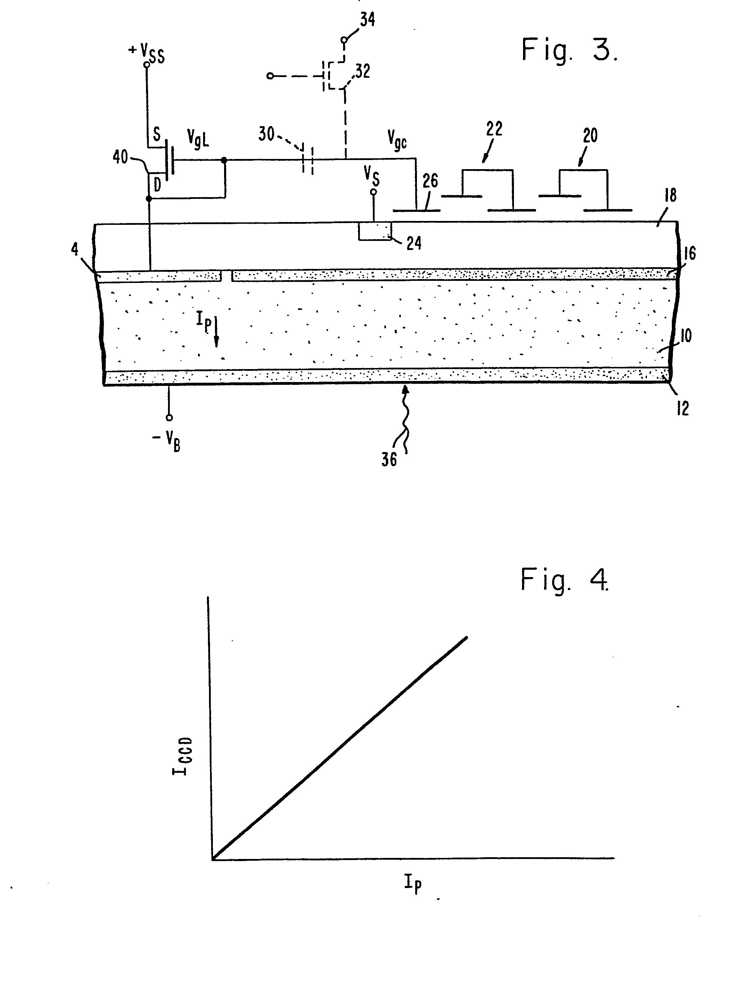

The foregoing problems are solved in the present invention which is illustrated schematically in FIG. 3. The underlying photodetector structure, including the indium doped silicon substrate 10, the photodiffusion 12, the photocurrent receiving diffusion 14, the n-type channel stop 16, the epitaxial silicon layer 18 and the output register 20 including the clocked transfer electrodes 22, the input diffusion 24 and the injection gate 26, is of a structure similiar to the device of FIG. 1 except that it includes a novel buffer amplifier. This novel amplifier comprises a buffer MOSFET 40 which has its drain and gate connected to the photocurrent-receiving diffusion 14 and to the CCD injection gate 26 and its source connected to a positive voltage $(+V_{ss})$. Because the drain of the buffer transistor 40 is connected to the photoreceiving diffusion 14, the bias voltage $V_b$ applied to the photodiffusion 12 must be negative, instead of positive as in the device of FIG. 1. This structure avoids the problems of the device of FIG. 1, including the problem of a nonlinear hyperbolic inverting transfer function. The transfer function, $(I_{CCD})/(I_p)$ of the device of FIG. 3 is illustrated in the graph of FIG. 4, showing that the output CCD current $I_{CCD}$ is a linear, non-inverting function of the photocurrent $I_p$. Because the photocurrent $I_p$ is directly proportional to the amount of incident radiation 36, the video output signal $I_{CCD}$ is a highly linear function of the image viewed by the photodiffusion 12. The reason for the highly linear response of the device of FIG. 3 will be discussed later in this specification.

Another advantage of the device of FIG. 3 is that the output current $I_{CCD}$ of charge packets transferred serially in the output register 20 is an exponential function of the difference between the threshold voltage $V_{tL}$ of the buffer transistor 40 and the threshold voltage $V_{tc}$ of the CCD injection gate 26. This may be expressed algebraically as:

$$I_{CCD} \sim \exp (V_{tL} - V_{tc})$$

Derivation of the foregoing algebraic expression will be given later in this specification. Because the output current $I_{CCD}$ depends upon the _difference_ and not upon the sum of the threshold voltages $V_{tc}$ and $V_{tL}$ (in contrast to the device of FIG. 1), the output response $I_{CCD}$ of the device of FIG. 3 will be substantially independent of variations in threshold voltage because the threshold voltages $V_{tL}$ and $V_{tc}$ are approximately equal to one another (so that their difference is _zero_) by virtue of the close proximity of the gate of the transistor 40 and the CCD injection gate 26 on the substrate 10. Consequently, the output current $I_{CCD}$ is virtually independent of variations in the threshold voltages $I_{tc}$ and $I_{tL}$. Therefore, in a CCD imager comprising a plurality of photodetector-output register pairs including buffer amplifiers of this invention, the response stored in each of the plurality of output registers 20 will be uniform even though the threshold voltages may vary widely between different photosensor-output register pairs.

As a result, the probability of saturating some of the plurality of output registers 20 in the CCD imager due to threshold voltage nonuniformities is virtually eliminated. Thus, the video signal produced by such a CCD imager has virtually no nonuniformities and the dynamic range of the device is increased.

As an example, in a CCD imager comprising a plurality of photosensor-output register pairs such as the one illustrated in FIG. 3, even though the threshold voltages $V_{tL}$ and $V_{tc}$ may vary by as much as 30 millivolts from a nominal value of -1.5 millivolts, the variation in the output CCD currents $I_{CCD}$ among the various photosensor-output register pairs will be substantially negligible.

Another advantage of the device of FIG. 3 is that the negative bias voltage $-V_b$ applied to the photodiffusion 12 causes that diffusion to be reverse biased with respect to the substrate 10 so that there is substantially no leakage current flowing between the photodiffusion 12 and the channel stop 16, in contrast to the significant leakage currents flowing in the prior art device of FIG. 1.

That the output current $I_{CCD}$ produced by the device of FIG. 3 should be a _linear_ function of the photocurrent $I_p$ as indicated in FIG. 4 may be understood from the following derivation. In the derivation that follows it is assumed that the buffer transistor 40 operates at near inversion where its gate voltage $V_{gL}$ is slightly less than its threshold voltage $V_{tL}$. Referring to FIG. 3, the current $I_{CCD}$ flowing in the output register 20 is well known to those skilled in the art to be given by the following equation:

$$(1) \quad I_{CCD} = I_{0c} \exp(-(V_{gc} - V_s - V_{tc} - K_c)/K_c),$$

where $K_c$ is a constant which is characteristic of the device parameters of the CCD register 20 and where $I_{0c}$ is the current flowing through the CCD register 20 whenever the argument of the exponent of equation 1 is equal to zero.

Similarly, it is well known by those skilled in the art that the current $I_p$ flowing from the source to the drain of the buffer transistor 40 is governed by the following equation:

$$(2) \quad I_p = I_{0L} \exp(-(V_{gL} - V_{ss} - V_{tL} - K_L)/K_L),$$

where $K_L$ is a constant which is characteristic of the device parameters of the MOSFET 40 and $I_{0L}$ is the amount of current flowing from the source to the drain of the MOSFET 40 whenever the argument of the exponent of equation 2 is equal to zero.

FIG. 3 shows that the gate of the buffer transistor 40 is connected directly to the CCD injection gate 26 and therefore the voltages on these two gates are equal, or:

$$(3) \quad V_{gc} = V_{gL}.$$

Substituting equation 3 into equation 2 and solving for $V_{gc}$, the following is obtained:

$$(4) \quad -V_{gc} = K_L \ln(I_p/I_{0L}) - V_{ss} - V_{tL} - K_L.$$

Substituting equation 4 into equation 1, the following is obtained:

$$(5) \quad I_{CCD} = I_p(I_{0c}/I_{0L})(K_L/K_c) \exp(-V_{ss} - V_s - V_{tc} + V_{tL} - K_c + K_L)/K_c).$$

In equation 5, all of the terms following the term $I_p$ are constants and do not substantially change with fluctuations in the photocurrent $I_p$. Therefore, these constants may be replaced by a single constant, c, and equation 5 may be rewritten as follows:

$$(6) \quad I_{CCD} = I_p (c).$$

From equation 6 it is clearly seen that the output current $I_{CCD}$ is a perfectly linear function of the photocurrent $I_p$. Because the photocurrent $I_p$ is a substantially linear function of the incident radiation 36, the video signal generated by the output current $I_{CCD}$ is a linear function of the radiation 36 incident on the photodiffusion 12. Thus, the slope of the linear graph of FIG. 4 is given by the constant c of equation 6.

Referring to equation 5, it is seen that the output current $I_{CCD}$ is a function of the difference, $-V_{tc} + V_{tL}$ of the threshold voltages of the injection gate 26 and of the MOSFET 40, as discussed previously. Because the MOSFET 40 is in close proximity to the injection gate 26, there will be very little or no difference between the two threshold voltages $V_{tc}$

and $V_{tL}$. As a result, the output current $I_{CCD}$ is substantially independent of the threshold voltages of the MOSFET 40 and of the CCD injection gate 26. Therefore, in a CCD imager comprising a plurality of photosensor-output register pairs such as the pair illustrated in FIG. 3, the output current $I_{CCD}$ from each pair will be uniform for a given amount of radiation 36 even though the threshold voltages $V_{tc}$ and $V_{tL}$ may vary widely between different pairs. As a result, there is very little risk of saturating the output CCD register 20 due to a deviation in threshold voltage and therefore the dynamic range of the device is significantly increased. Furthermore, substantially no nonuniformities are introduced into the video signal generated by a plurality of output registers 20.

In an alternative embodiment of the invention, the coupling capacitor 30 may be interposed between the gate of the MOSFET 40 and the CCD injection gate 26, and one of the plates of the capacitor 30 may be reset periodically by a reset transistor 32 connected to a reset voltage supply 34, and a reset clock signal may be periodically applied to the gate of the transistor 32.

Other variations of the invention from the specific embodiment illustrated in FIG. 3 are possible. For instance, the substrate 10 may be of a different material from the exemplary indium doped silicon suggested in this specification. In fact, the photo-sensor comprising the indium doped substrate 10, the photodiffusion 12 and the photocurrent-receiving diffusion 14 may be of any structure which generates a photocurrent in response to incident radiation. It may be possible to use a photosensor which generates negative minority carriers (electrons) so that the device would be an n-channel device formed on a p-type substrate, the buffer transistor 40 and the CCD output register 20 being p-channel devices. Furthermore, the charge injection device comprising the input diffusion 24 and the injection gate 26 may be of any other type of charge injection device known in the art.

RMW:mv
[41-7]

## CLAIMS

What is Claimed is:

1. A photodetector buffer for a charge transfer device comprising:

a photodetector including a photocurrent output terminal and a bias voltage terminal;

a charge transfer device;

a charge flow control electrode overlying said charge transfer device;

a field effect transistor having a source, a drain and a gate, said gate connected to said control electrode, said drain connected to said gate and to said photocurrent output terminal; and

means for applying operating voltages to said bias terminal and said source.

2. The device of Claim 1 further comprising a capacitor having two plates connected between said gate and said control electrode so as to interrupt direct current flow between said gate and said electrode, one of said two plates being periodically reset to a selected potential.

3. The device of Claim 1 wherein said field effect transistor and said charge transfer device are formed on a single semiconductive substrate.

4. The device of Claim 3 wherein said substrate is of p-type conductivity and said charge transfer device and said field effect transistor are p-channel devices.

5.  The device of Claim 1 wherein said charge transfer device is a charge coupled device transferring a current of charge packets which is a linear function of the amount of radiation incident upon said photo-detector.

## Fig. 1.

## Fig. 2.

Fig. 3.

Fig. 4.